# EUROPÄISCHE PATENTANMELDUNG

(11) **EP 0 673 065 A1**
(43) Veröffentlichungstag der Anmeldung: **20.09.1995**
(21) Anmeldenummer: 95103439.6
(22) Anmeldetag: 09.03.1995
(51) Int. Cl.: H01L 23/40

(54) **Vorrichtung zum Kühlen von elektronischen Bauelementen**

(30) Priorität: 16.03.1994 DE 4409016
(71) Anmelder: Siemens Nixdorf Informationssysteme AG, D-33106 Paderborn (DE)
(72) Erfinder: Bachl, Johann, Dipl. Ing., D-80638 München (DE)
(74) Vertreter: Fuchs, Franz-Josef, Dr.-Ing.

(57) **Zusammenfassung**

Zum Kühlen von elektronischen Bauelementen (2), die beiderseits einer Trägerplatte (1) einer elektronischen Baugruppe angeordnet sind, wird vorgeschlagen, für jeweils auf der einen und auf der anderen Seite der Trägerplatte (1) angeordnete zu kühlende elektronische Bauelemente zwei jeweils einer der Seiten der Trägerplatte (1) zugeordnete Kühlkörper (4, 5) vorzusehen, die an einem jeweiligen Rand jeweils mit einem der Schenkelenden eines U-förmigen federnden Bügels (8) verbunden sind derart, daß die Kühlkörper (4, 5) mit aufeinander zuweisenden, wenigstens im wesentlichen parallel zueinander ausgerichteten Auflagenflächen (6) mit einem Abstand zwischen den Auflageflächen (6) geringfügig kleiner als die Dicke der Trägerplatte (1), zuzüglich der Dicken der auf den jeweiligen Seiten der Trägerplatte (1) angeordneten zu kühlenden elektronischen Bauelemente (2) angeordnet sind.

## Beschreibung

Die Erfindung betrifft eine Vorrichtung zum Kühlen von elektronischen Bauelementen gemäß dem Oberbegriff des Anspruchs 1.

Zum Betreiben von elektronischen Baugruppen muß die von den zugehörigen, auf einer Trägerplatte angeordneten elektronischen Bauelementen erzeugte Verlustwärme über ein Kühlsystem abgeführt werden. Dies ist insbesondere bei der Anwendung von in ECL-Technik gefertigten elektronischen Bauelementen notwendig.

Es ist bekannt, Kühlkörper durch Kleben oder mechanische Verfahren direkt auf den elektronischen Bauelementen zu befestigen. Hierfür ist ein großer Arbeitsaufwand notwendig.

Die Anschlüsse der elektronischen Bauelemente werden immer feiner und daher immer empfindlicher gegenüber mechanischen Belastungen. Demgegenüber werden die Kühlkörper immer größer, damit sie die infolge der immer höheren Integrationsdichte in den elektronischen Bauelementen verursachte erhöhte Verlustwärme abführen können.

Aufgabe der Erfindung ist es, eine Vorrichtung zum Kühlen von elektronischen Bauelementen der eingangs genannten Art anzugeben, die auch für elektronische Bauelemente mit sehr feinen Anschlüssen und hoher Integrationsdichte geeignet ist.

Diese Aufgabe wird durch die im kennzeichnenden Teil des Anspruchs 1 angegebenen Merkmale gelöst.

Danach werden die Kühlkörper nicht mehr direkt auf den elektronischen Bauelementen befestigt sondern nur mehr angedrückt. Eine Belastung für die Anschlüsse der elektronischen Bauelemente ist daher nurmehr durch eine Andruckkraft des Kühlkörpers und eventuell durch eine seitliche Schubkraft durch Reibung verursacht.

Vorteilhafte Ausgestaltungen der Erfindung sind Gegenstand von Unteransprüchen.

Die Ausgestaltung des U-förmigen federnden Bügels als Bi-Metallelement mit der Eigenschaft des Aufeinanderzugehens der Schenkelenden bei Erwärmung des U-förmigen federnden Bügels hat den Vorteil, daß bei einer immer höheren Aufheizung eines elektronischen Bauelementes ein immer intensiverer Kontakt mit dem Kühlkörper hergestellt wird, der zu einer immer besseren Wärmeableitung beiträgt.

Werden zwischen den mit den Schenkelenden des U-förmigen federnden Bügels verbundenen Rändern der Kühlkörper und den Schenkelenden des U-förmigen federnden Bügels Bewegungsausgleichselemente angeordnet, die bei einem Aufeinanderzugehen der Schenkelenden des U-förmigen federnden Bügels einen Bewegungsausgleich in der Weise durchführen, daß die Auflagenflächen der Kühlkörper stets wenigstens im wesentlichen parallel zu einander gehalten werden, ist gewährleistet, daß die Kühlkörper stets mit einem weitgehendst gleichmäßig verteilten Flächenandruck auf den zu kühlenden elektronischen Bauelementen aufliegen.

Nachfolgend wird ein Ausführungsbeispiel der Erfindung anhand einer Zeichnung näher erläutert.

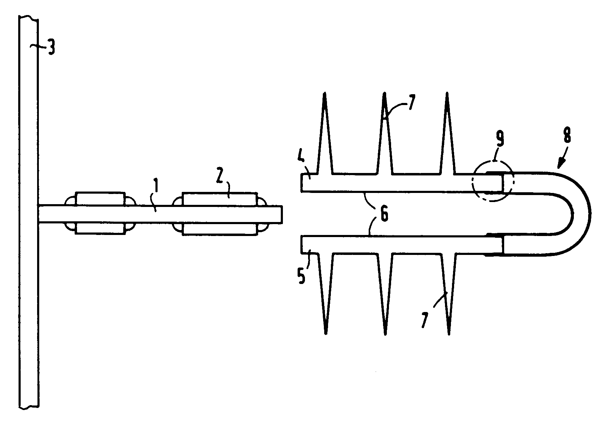

In der Figur sind eine Trägerplatte 1 einer elektronischen Baugruppe gezeigt. Die Trägerplatte 1 ist beiderseits mit elektronischen Bauelementen 2 bestückt. Wie in der Figur 1 angedeutet, ist die Trägerplatte 1 in einer Verdrahtungsplatte 3, beispielsweise einer solchen einer Rechnereinheit, eingesteckt angeordnet.

Zur Kühlung der elektronischen Bauelemente 2 der Trägerplatte 1 sind zwei Kühlkörper 4, 5 vorgesehen. Die Kühlkörper 4, 5 weisen Auflagenflächen 6 und Kühlflächen 7 auf. Die Kühlfläche 7 ist gemäß der Figur durch die profilierte Oberfläche der Kühlkörper 4, 5 gebildet, über die Wärme an die Umgebungsluft als Kühlmedium abgegeben werden kann. Die Kühlkörper 4, 5 könnten auch ein Rohrsystem enthalten, in dem beispielsweise ein flüssiges Kühlmittel als Kühlmedium geführt wird. Die Kühlfläche würde dann durch die Innenwandung des Rohrsystems gebildet sein. Die Kühlkörper 4, 5 hätten dann quasi die Funktion eines Wärmetauschers. Eine Kombination beider Kühlungsarten wäre ebenso denkbar. Die Verbindung des Rohrsystems eines Kühlkörpers mit dem Rohrsystem eines anderen Kühlkörpers könnte vorteilhafterweise mit flexiblen Rohrleitungen wie zum Beispiel Gummischläuchen gebildet sein.

Gemäß der Figur ist der Kühlkörper 4 der einen und der Kühlkörper 5 der anderen Seite der Trägerplatte 1 zugeordnet.

Den Kühlkörpern 4, 5 ist ein U-förmiger federnder Bügel 8 zugeordnet. Dabei ist der U-förmige federnde Bügel 8 mit den Kühlkörpern 4, 5 verbunden. Die Verbindung ist derart, daß jeweilige Ränder der Kühlkörper 4, 5 mit jeweils einem der Schenkelenden des U-förmigen federnden Bügels 8 verbunden sind. Die Kühlkörper 4, 5 sind dabei in einer solchen Weise angeordnet, daß die Auflagenflächen 6 der einzelnen Kühlkörper aufeinander zuweisen und wenigstens im wesentlichen parallel zueinander verlaufen. Ferner sind die Kühlkörper 4, 5 in einer solchen Weise angeordnet, daß zwischen den Auflagenflächen 6 ein Abstand ausgebildet ist, der geringfügig kleiner ist als die Dicke der Trägerplatte 1, zuzüglich der Dicken der auf den jeweiligen Seiten der Trägerplatte 1 angeordneten zu kühlenden elektronischen Bauelemente 2.

Die Kühlkörper 4, 5 und der U-förmige federnde Bügel 8 bilden zusammen eine Art U-förmige Spange, die auf die Trägerplatte 1 mit den zu kühlenden elektronischen Bauelementen 2 aufgezwickt wird. Durch den gegenüber der Dicke der Trägerplatte 1, zuzüglich der Dicken der auf den jeweiligen Seiten der Trägerplatte 1 angeordneten zu kühlenden elektronischen Bauelemente 2 etwas kleiner gewählten Abstand zwischen den Auflagenflächen 6 der Kühlkörper 4, 5 und durch die federnde Wirkung des U-förmigen federnden Bügels 8 wird eine Selbsthemmung erzeugt, durch die sich die Kühlkörper 4, 5 von alleine auf den zu kühlenden elektronischen Bauelementen 2 halten. Gleichzeitig ist durch den federnden Auflagendruck ein guter Wärmeübergang zwischen den zu kühlenden elektronischen Bauelementen 2 und den Kühlkörpern 4, 5 sichergestellt. Eine Verklebung zwischen den zu kühlenden elektronischen Bauelementen 2 und den Kühlkörpern 4, 5 ist daher nicht nötig. Bei unterschiedlichen Wärmeausdehnungen zwischen einzelnen zu kühlenden elektronischen Bauelementen 2 sind Ausgleichsbewegungen der elektronischen Bauelemente 2 gegenüber den Kühlkörpern 4, 5 möglich, so daß es zu keinen Verspannungen im Gefüge kommt. Das wäre der Fall, wenn die zu kühlenden elektronischen Bauelemente 2 an den Kühlkörpern 4, 5 festgeklebt wären. Die Anschlüsse der elektronischen Bauelemente 2 sind dadurch wesentlich von einer mechanischen Belastung entlastet. Eine mechanische Belastung der Anschlüsse der elektronischen Bauelemente 2 erfolgt lediglich durch die Andruckkraft des Kühlkörpers und durch eine seitliche Schubkraft durch Reibung. Die senkrecht auf die zu kühlenden elektronischen Bauelemente 2 wirkende Andruckkraft kann durch Abstützen auf der Trägerplatte 1 durch die jeweiligen elektronischen Bauelemente 2 selbst abgefangen werden.

Der U-förmige federnde Bügel 8 kann durch wenigstens eine Blattfeder gebildet sein. Er kann aber auch durch ein Bi-Metallelement gebildet sein mit der Eigenschaft des Aufeinanderzugehens der Schenkelenden des U-förmigen federnden Bügels 8 bei Erwärmung. Dies hat den Vorteil, daß bei Erhöhung der Verlustleistung in einem elektronischen Bauelement 2 der Andruck ebenfalls erhöht wird, wodurch sich ein verbesserter Wärmeübergang und eine verbesserte Wärmeabführung ergibt.

Zwischen den mit den Schenkelenden des U-förmigen federnden Bügels 8 verbundenen Rändern der Kühlkörper 4, 5 und den Schenkelenden des U-förmigen federnden Bügels 8 können Bewegungsausgleichselemente 9 vorgesehen sein, die eine Ausgleichsbewegung bewirken, wenn die Schenkelenden des U-förmigen federnden Bügels 8 aufgrund einer Erwärmung aufeinander zugehen. Die Ausgleichsbewegung kann in der Form durchgeführt werden, daß stets eine parallel Anordnung der Auflagenflächen 6 der Kühlkörper 4, 5 gewährleistet ist. Die Bewegungsausgleichselemente 9 könnten beispielsweise durch elastische Elemente gebildet sein, die jeweils soweit einknicken, daß die erwähnte Folge eintritt. Vorteilhaft ist der Bügel 8 bei eingeschobener Trägerplatte 1 formschlüssig gesichert.

Die Kühlkörper 4, 5 und der U-förmige federnde Bügel 8 könnten für einfache Anwendungen vorteilhafterweise aus einem Strangguß-Material gefertigt werden.

## Patentansprüche

1. Vorrichtung zum Kühlen von elektronischen Bauelementen, die beiderseits einer Trägerplatte einer elektronischen Baugruppe angeordnet sind, mittels Kühlkörper, die eine plane Auflagefläche zum Aufliegen auf zu kühlende elektronische Bauelemente und eine Kühlfläche zum Abgeben einer über die Auflagefläche aufgenommenen Wärmemenge an ein Kühlmedium aufweisen, **dadurch gekennzeichnet,**
daß für zu kühlende elektronische Bauelemente (2) jeweils auf der einen und auf der anderen Seite der Trägerplatte (1) zwei jeweils einer der Seiten der Trägerplatte (1)zugeordnete Kühlkörper (4, 5) vorgesehen sind, die an einem jeweiligen Rand jeweils mit einem der Schenkelenden eines U-förmigen federnden Bügels (8) verbunden sind derart, daß die Kühlkörper (4, 5) mit aufeinander zuweisenden, wenigstens im wesentlichen parallel zueinander ausgerichteten Auflagenflächen (6) mit einem Abstand zwischen den Auflageflächen (6) geringfügig kleiner als die Dicke der Trägerplatte (1), zuzüglich der Dicken der auf den jeweiligen Seiten der Trägerplatte (1) angeordneten zu kühlenden elektronischen Bauelemente (2) angeordnet sind.

2. Vorrichtung nach Anspruch 1, **dadurch gekennzeichnet,**
daß der U-förmige federnde Bügel (8) durch wenigstens eine Blattfeder gebildet ist.

3. Vorrichtung nach Anspruch 1 oder 2, **dadurch gekennzeichnet,**
daß der U-förmige federnde Bügel (8) durch ein Bi-Metallelement gebildet ist mit der Eigenschaft des Aufeinanderzugehens der Schenkelenden des U-förmigen federnden Bügels (8) bei Erwärmung des U-förmigen federnden Bügels 8).

4. Vorrichtung nach einem der vorherigen Ansprüche, **dadurch gekennzeichnet,**
daß zwischen den mit den Schenkelenden des U-förmigen federnden Bügels (8) verbundenen Rändern der Kühlkörper (4, 5) und den Schenkelenden des U-förmigen federnden Bügels (8) Bewegungsausgleichselemente (9) vorgesehen sind, die bei einem Aufeinanderzugehen der Schenkelenden des U-förmigen federnden Bügels (8) einen Bewegungsausgleich derart vornehmen, daß die Auflagenflächen (6) der Kühlkörper (4, 5) stets wenigstens im wesentlichen parallel zueinander verlaufen.

5. Vorrichtung nach einem der vorherigen Ansprüche, **dadurch gekennzeichnet,**
daß die Kühlkörper (4, 5) und der U-förmige federnde Bügel (8) einstückig aus Strangguß-Material gebildet sind.

6. Vorrichtung nach einem der vorherigen Ansprüche, **dadurch gekennzeichnet,**
daß die Kühlkörper (4, 5) als Wärmetauscher für ein in einem Röhrensystem geführtes Kühlmittel ausgebildet und untereinander mit flexiblen Rohrleitungen verbunden sind.
